# EUROPEAN PATENT SPECIFICATION

(11) **EP 2 908 337 B1**
(45) Date of publication and mention of the grant of the patent: **12.11.2025**
(21) Application number: 14154852.9
(22) Date of filing: 12.02.2014
(51) Int. Cl.: H01L 23/48, H01L 23/485, H01L 23/31, H01L 23/00

(54) **Semiconductor device with a thermally stable bump contact on a TSV and method of producing such a semiconductor device**
Halbleitervorrichtung mit einem thermostabilen Stoßkontakt auf einem TSV und Verfahren zur Herstellung einer solchen Halbleitervorrichtung
Dispositif à semi-conducteur avec plot de contact thermiquement stable sur un TSV et procédé de production d'un tel dispositif à semi-conducteur

(43) Date of publication of application: 19.08.2015
(73) Proprietor: ams AG, 8141 Premstätten (AT)
(72) Inventor: Schrems, Martin, 8063 Eggersdorf (AT); Stering, Bernhard, 8510 Stainz (AT); Etschmaier, Harald, 8010 Graz (AT)
(74) Representative: Epping - Hermann - Fischer

(56) References cited:
- DE-A1- 102009 012 643
- US-A1- 2009 243 047
- US-A1- 2011 272 801
- US-A1- 2013 026 645
- US-A1- 2013 249 098
- US-A1- 2013 328 209

## Description

The increasing density of components that are integrated in semiconductor devices requires an increasing density of electrical interconnections between these components. This may be achieved with the aid of through substrate vias (TSVs), which have typical diameters in the range from 2 µm to 100 µm. It may be preferable not to fill the TSVs with electrically conductive material in order to reduce thermal stress occurring in the semiconductor substrate. Unfilled TSVs may be closed, but the closure is easily damaged when the ambient temperature rises and gas remaining inside the closed TSV expands. This may especially happen during reflow soldering in the manufacturing process.

US 8,310,058 B2 discloses a semiconductor device comprising a TSV formed in the substrate by deposition of an electrically conductive material. An under-bump metallization (UBM) layer is formed on a backside of the substrate in electrical contact with the TSV. A solder material is deposited on the UBM layer and reflowed to form a solder bump.

US 2010/0171209 A1 discloses a semiconductor device formed with stacked semiconductor chips having hollow TSVs, each of which has a tapered portion. The chips are connected to one another by solder balls, which comprise a core of a material that has a higher melting point than the surrounding solder material. The diameter of the core can be adapted to reduce stress occurring around the electrode.

US 2013/0026645 A1 discloses a semiconductor component comprising a conductive through-substrate via, which is provided with a recess through a conductive pad, to improve the performance of the component, particularly when there is a mismatch between the coefficients of thermal expansion.

DE 10 2009 012 643 A1 discloses a connecting structure for electronic devices. Contact elements penetrating the silicon substrate are formed as piles and surrounded by void regions to allow the elements to perform two-dimensional movements in the case of thermal expansion or mechanical stress.

US 2013/0249098 A1 discloses a semiconductor device with a layer for protecting TSV tips during thermo-compressive bonding. The TSV tips are covered with metal caps and a protective layer.

US 2013/0328209 A1 discloses a stack arrangement including a semiconductor substrate with a via and an interconnection on a bond pad portion below the via. The circumference of the bond pad may include a plurality of discontinuous portions.

US 2009/0243047 A1 discloses a semiconductor device with a conductor inside a through hole of the substrate. The conductor forms a conductor bump outside the through hole. At a lower part of the through hole, an insulation is provided by a dielectric flexible material filling a gap.

US 2011/0272801 A1 discloses a semiconductor device with connection pads provided with inserts. Cavities are filled with a material that is different from the material of the pads, in particular with silicon oxide.

US 2013/0040453 A1 discloses a method of forming an UBM layer over a plurality of TSVs. The UBM is connected to a selected portion of the TSVs in common.

US 2013/0087893 A1 discloses a semiconductor substrate comprising a plurality of TSVs. A conductive filler is disposed in each TSV with a void left in the centre to reduce the thermal stress in the semiconductor substrate.

It is an object of the present invention to disclose a semiconductor device with thermomechanically stable bump contacts on unfilled TSVs. It is a further object of the invention to disclose a method of producing such a device.

This object is achieved with the semiconductor device according to claim 1 and with the method of producing a semiconductor device according to claim 4. Embodiments and variants derive from the dependent claims. The invention is set out in the appended set of claims.

The semiconductor device comprises a semiconductor substrate with a main surface and a further main surface opposite the main surface, a TSV (through-substrate via) penetrating the substrate from the main surface to the further main surface, a cover layer arranged above the TSV at the main surface, a bump contact arranged on the TSV at the further main surface, and a stress relief feature at the main surface or at the further main surface. The stress relief feature is provided to expose the TSV at least partially to the environment, which can be the ambient air, for instance, or any region of the device outside the region occupied by the TSV. The stress relief feature thus provides a communication between the TSV and the environment.

An under-bump metallization is arranged on the TSV at the further main surface, the bump contact is arranged on the under-bump metallization. In a first embodiment, a channel in the under-bump metallization forms the stress relief feature. The under-bump metallization and the bump contact cover a cavity of the TSV, and the channel connects the cavity with the environment.

In a second embodiment, a predetermined breaking point formed by a region arranged in the under-bump metallization forms the stress relief feature.

In this second embodiment, the predetermined breaking point is arranged in such a manner that a crack or fissure occurring in the predetermined breaking point connects the cavity with the environment.

In this second embodiment, the predetermined breaking point is formed from a material having a lower fracture strength than the under-bump metallization.

In a further embodiment, the predetermined breaking point may be formed as a striplike region within the under-bump metallization.

The cavity of the TSV can be occupied by a gas or a liquid.

The method of producing embodiments of such a semiconductor device comprises providing a semiconductor substrate with a TSV penetrating the substrate from a main surface to an opposite further main surface, arranging a cover layer above the TSV at the main surface, arranging an under-bump metallization and a bump contact on the TSV at the further main surface. A first embodiment further comprises forming a stress relief feature in the under-bump metallization by forming a channel in the under-bump metallization, the channel connecting the cavity with the environment.

In a second embodiment of the method the stress relief feature is formed by a predetermined breaking point.

The following is a detailed description of examples of the semiconductor device and of examples of the method for producing the semiconductor device.
- Figure 1: is a cross section of a semiconductor device not being part of the present invention.
- Figure 2: is a schematic top view of a bump contact according to Figure 1.
- Figure 3: is a cross section of the first embodiment of the semiconductor device comprising a venting channel.
- Figure 4: is a schematic top view of a bump contact of an embodiment comprising a venting channel.
- Figure 5: is a schematic top view of a bump contact of the embodiment according to Figure 3.
- Figure 6: is a cross section of the second embodiment of the semiconductor device comprising a predetermined breaking point.
- Figure 7: is a schematic top view of a bump contact of an embodiment comprising a predetermined breaking point.
- Figure 8: is a schematic top view of a bump contact of the embodiment according to Figure 6.
- Figure 9: is a cross section of a semiconductor device comprising a pierced cover layer on the TSV, which is not part of the present invention.
- Figure 10: is a schematic top view of a bump contact of the embodiment according to Figure 9.

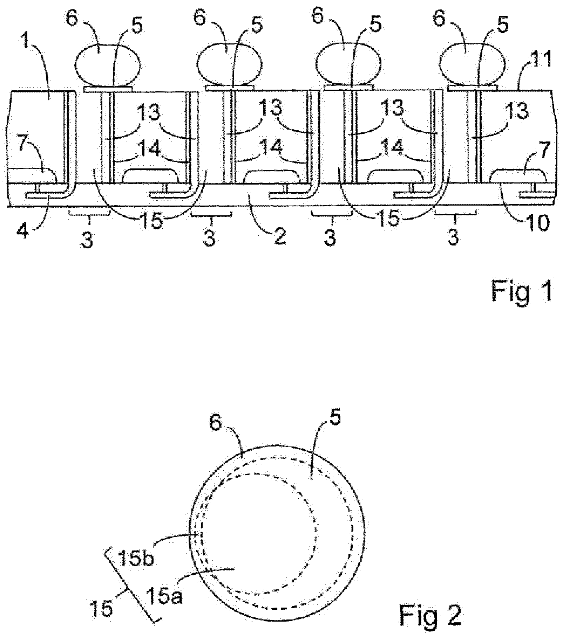

Figure 1 is a cross section of a semiconductor device not being part of the present invention comprising a semiconductor substrate 1 with a main surface 10 and a further main surface 11 opposite the main surface 10. A cover layer 2 is arranged on the main surface 10. The cover layer 2 may be a dielectric layer, for instance, or it may be a wiring layer comprising structured metal layers 4 and interconnections of a wiring embedded in dielectric material. Details of the cover layer 2 are not relevant to the invention.

The substrate 1 comprises at least one through-substrate via 3, abbreviated TSV, including a metallization 13, which is preferably insulated from the semiconductor material of the substrate 1 by dielectric material forming a sidewall 14, and a central cavity 15, which may be filled with a gas or liquid, for instance. The TSV 3 is provided as an electrical connection between electrical conductors that are arranged on or above the main surface 10 and further electrical conductors that are arranged on or above the further main surface 11. The TSV 3 may especially be provided to connect a terminal of a circuit component 7 that is integrated in the semiconductor substrate 1 with an electrical terminal that is arranged on or above the further main surface 11. The semiconductor substrate 1 can instead be a passive component, especially a component used as an interposer for a redistribution of electrical connections, for instance.

The cover layer 2 closes the cavity 15 of the TSV 3 at the main surface 10. A bump contact 6, which may be a solder ball, for instance, is arranged on an under-bump metallization 5, which partially covers the cavity 15 of the TSV 3 at the further main surface 11 and is connected with the metallization 13. The cavity 15 is not completely closed by the under-bump metallization 5 and by the bump contact 6, which are placed slightly laterally with respect to a centre of the TSV 3. The remaining small opening of the cavity 15 serves as a venting channel.

Figure 2 is a schematic top view of the bump contact 6 according to Figure 1. The hidden circular contour of the TSV 3, which is cylindrical in this example, and the hidden circular contour of the under-bump metallization 5 are indicated with broken lines. In further embodiments, the area of the under-bump metallization 5 can be different from a circle, and the TSV 3 need not be cylindrical. Figure 2 shows a covered area 15a of the cavity 15 of the TSV 3 where the under-bump metallization 5 is present, and an uncovered area 15b of the cavity 15. The bump contact 6 may cover the whole area of the TSV 3 without closing it, as can be seen from Figure 1. Instead, the perpendicular projection of the bump contact 6 into the plane of the further main surface 11 may not completely cover the area of the TSV 3.

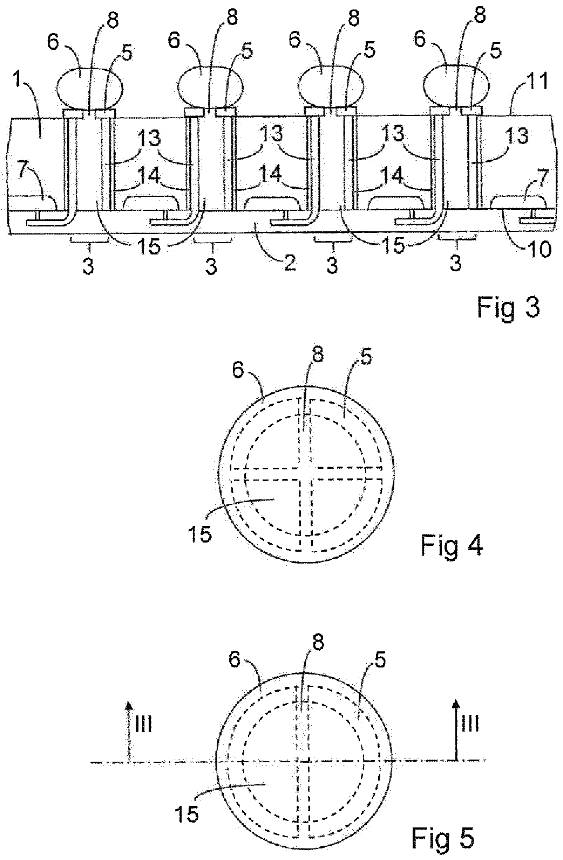

Figure 3 is a cross section of an embodiment of the semiconductor device comprising a channel 8 in the layer of the under-bump metallization 5. Elements of the embodiment according to Figure 3 that correspond to elements according to Figure 1 are designated with the same reference numerals. In the embodiment according to Figure 3, the under-bump metallization 5 comprises a channel 8, which provides a connection between the cavity 15 of the TSV 3 and the environment, in particular the ambient air. The channel 8 thus functions as a venting channel. The bump contact 6 spans the channel 8.

Figure 4 is a schematic top view of a bump contact 6 of an embodiment comprising a channel 8 within the layer of the under-bump metallization 5. In this embodiment the under-bump metallization 5 can be placed centrally with respect to the TSV 3. The under-bump metallization 5 has a larger diameter than the cavity 15 of the TSV 3 and overlaps the borders of the cavity 15 as shown in Figure 4. The channel 8 can have any shape, provided that the channel 8 connects the central region of the under-bump metallization 5 with its periphery in such a manner that the cavity 15 communicates with the environment. In the embodiment according to Figure 4, the channel 8 comprises two straight passages, which are arranged along diameters of the under-bump metallization 5 at a right angle. Arrangement and shape of the channel 8 are not restricted to the example represented in Figure 4. The function of the channel 8 is not adversely affected by small residual amounts of solder resist adhering to the sidewalls of the under-bump metallization 5.

Figure 5 is a schematic top view of the bump contact 6 of the embodiment according to Figure 3. Here the channel 8 comprises only one straight passage along a diameter of the under-bump metallization 5. The position of the cross section of Figure 3 is indicated in Figure 5 by the straight line of dots and dashes.

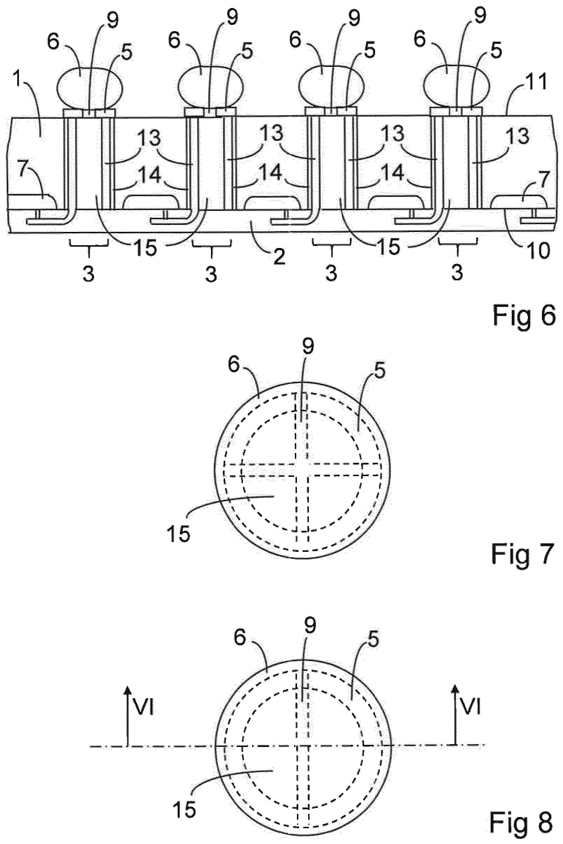

Figure 6 is a cross section of a further embodiment of the semiconductor device comprising a predetermined breaking point 9 in the layer of the under-bump metallization 5. Elements of the embodiment according to Figure 6 that correspond to elements of the embodiment according to Figure 3 are designated with the same reference numerals. In the embodiment according to Figure 6, the under-bump metallization 5 is provided with a region comprising a different material forming a predetermined breaking point 9, which is spanned by the bump contact 6. The region in question can be similar to the venting channel described above in conjunction with Figures 3 to 5. The channel is not left open but filled with a material that has a lower fracture strength than the material of the under-bump metallization 5. Stress occurring in the layer of the under-bump metallization 5 is therefore liable to cause cracks or fissures in the material of the predetermined breaking point 9, so that a channel venting the cavity 15 is produced. The predetermined breaking point 9 thus serves as a pressure relief valve protecting the TSV 3.

Figure 7 is a schematic top view of a bump contact 6 of an embodiment comprising a predetermined breaking point 9 within the layer of the under-bump metallization 5. In this embodiment the under-bump metallization 5 can be placed centrally with respect to the location of the TSV 3. The under-bump metallization 5 has a larger diameter than the cavity 15 of the TSV 3 and overlaps the borders of the cavity 15 as shown in Figure 7. The region of the predetermined breaking point 9 can have any shape, provided that it connects the central region of the under-bump metallization 5 with its periphery in such a manner that cracks or fissures generated in the predetermined breaking point 9 can form a channel venting the cavity 15. In the embodiment according to Figure 7, the predetermined breaking point 9 comprises two straight striplike regions arranged along diameters of the under-bump metallization 5 at a right angle.

Figure 8 is a schematic top view of the bump contact 6 of the embodiment according to Figure 6. The predetermined breaking point 9 comprises only one straight striplike region arranged along a diameter of the under-bump metallization 5. The position of the cross section of Figure 6 is indicated in Figure 8 by the straight line of dots and dashes.

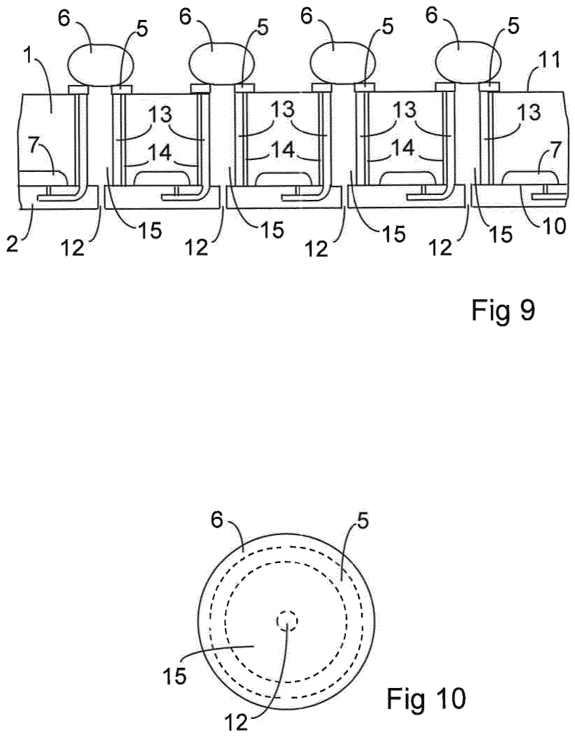

Figure 9 is a cross section of a semiconductor device that is not part of the present invention and comprises a TSV 3 with a venting hole 12 in the cover layer 2 on the main surface 10 of the semiconductor substrate 1. Elements of the embodiment according to Figure 9 that correspond to elements of the embodiment according to Figure 6 are designated with the same reference numerals. In the embodiment according to Figure 9, the hole 12 penetrating the cover layer 2 connects the cavity 15 of the TSV 3 with the environment, in particular with the ambient air. The TSV 3 is thus almost completely closed, and the bump contact 6 is allowed to cover the TSV 3 completely at the further main surface 11. Contamination of the TSV 3 by underfill material or the like entering the cavity 15 can thus be prevented, and stress owing to an extension of gas inside the cavity 15 is prevented at the same time.

Figure 10 is a schematic top view of the bump contact 6 of the example of Figure 9. The outline of the position of the hole 12 is indicated with a circular broken line in the centre of the area representing the cavity 15. The hole 12 can be arranged at any other suitable position in the area of the cavity 15, and there may be two or more such holes 12 in the cover layer 2 for the same TSV 3.

The invention has the advantage that fractures in the metallization of the TSV, in the material of the bump contacts or in the under-bump metallization are avoided even under changing ambient temperatures. If expanding liquids or gases enclosed within the TSV can escape through a venting channel, the risk of damages of bump contacts allowing small lateral dimensions of the semiconductor device is reduced. Thus the bump contacts are thermally stable. Underfill material, which may be employed to fix the device on a printed circuit board, is less likely to contaminate the interior of the TSV. The invention is especially favourable for unfilled TSVs, i. e., for TSVs that are not filled with solid material but may contain a gas or a liquid. In examples that are not covered by the present invention, some of the features of the present invention can also be employed for TSVs filled with a metal or dielectric material. In each case an effective stress relief is provided at the interface between the under-bump metallization and the bump contact and/or the filling material.

### List of reference numerals

- 1: semiconductor substrate
- 2: cover layer
- 3: TSV
- 4: metal layer
- 5: under-bump metallization
- 6: bump contact
- 7: integrated circuit component
- 8: channel
- 9: predetermined breaking point
- 10: main surface
- 11: further main surface
- 12: hole
- 13: metallization
- 14: sidewall
- 15: cavity
- 15a: covered area of the cavity
- 15b: uncovered area of the cavity

## Claims

1. A semiconductor device, comprising:
- a semiconductor substrate (1) having a main surface (10) and a further main surface (11) opposite the main surface (10),
- a TSV (3) penetrating the substrate (1) from the main surface (10) to the further main surface (11), the TSV (3) comprising a cavity (15),
- a cover layer (2) arranged above the TSV (3) at the main surface (10),
- a bump contact (6) arranged on the TSV (3) at the further main surface (11), and
- an under-bump metallization (5) arranged on the TSV (3) at the further main surface (11), the bump contact (6) being arranged on the under-bump metallization (5), **characterized in that**
- the cover layer (2) closes the cavity (15) at the main surface (10),
- the under-bump metallization (5) and the bump contact (6) cover the cavity (15), and wherein
- (i) a channel (8) is formed in the under-bump metallization (5), the channel (8) connecting the cavity (15) with an environment, thus forming a stress relief feature at the further main surface (11), the stress relief feature providing a communication between the TSV (3) and the environment, or
- (j) a predetermined breaking point is formed a region arranged within the layer of the under-bump metallization (5), said region being filled with a material that has a lower fracture strength than the material of the under-bump metallization in such a manner that a crack or fissure occurring in said region connects the cavity (15) with the environment, said region thus forming a stress relief feature.

2. The semiconductor device of claim 1, wherein the predetermined breaking point region (9) is formed as a striplike region within the under-bump metallization (5).

3. The semiconductor device of one of claims 1 to 2, wherein the cavity (15) of the TSV (3) is filled with a gas or a liquid.

4. A method of producing a semiconductor device, comprising:
- providing a semiconductor substrate (1) with a TSV (3) penetrating the substrate (1) from a main surface (10) to an opposite further main surface (11), the TSV (3) comprising a cavity (15),
- arranging a cover layer (2) above the TSV (3) at the main surface (10), and
- arranging an under-bump metallization (5) and a bump contact (6) on the TSV (3) at the further main surface (11), the bump contact (6) being arranged on the under-bump metallization (5),
**characterized in that**
- the cavity (15) is closed at the main surface (10) by the cover layer (2), and wherein
- (i) a channel (8) is formed in the under-bump metallization (5), the channel (8) connecting the cavity (15) with the environment, the channel (8) thus forming a stress relief feature, or
- (j) a predetermined breaking point (9) is formed by a region arranged within the layer of the under-bump metallization, said region being filled with a material that has a lower fracture strength than the material of the under-bump metallization in such a manner that a crack or fissure occurring in said region connects the cavity (15) with the environment, said predetermined breaking point thus forming a stress relief feature.

## Patentansprüche

1. Halbleiterbauelement, umfassend:
- ein Halbleitersubstrat (1) mit einer Hauptoberfläche (10) und einer weiteren Hauptoberfläche (11) gegenüber der Hauptoberfläche (10),
- ein TSV (3), das das Substrat (1) von der Hauptoberfläche (10) zur weiteren Hauptoberfläche (11) durchdringt, wobei das TSV (3) einen Hohlraum (15) umfasst,
- eine Deckschicht (2), die über dem TSV (3) an der Hauptoberfläche (10) angeordnet ist,
- einen auf dem TSV (3) an der weiteren Hauptoberfläche (11) angeordneten Bump-Kontakt (6) und
- eine auf dem TSV (3) an der weiteren Hauptoberfläche (11) angeordnete Under-Bump-Metallisierung (5), wobei der Bump-Kontakt (6) auf der Under-Bump-Metallisierung (5) angeordnet ist,
**dadurch gekennzeichnet, dass**
- die Deckschicht (2) den Hohlraum (15) an der Hauptoberfläche (10) verschließt,
- die Under-Bump-Metallisierung (5) und der Bump-Kontakt (6) den Hohlraum (15) bedecken, und wobei
- (i) in der Under-Bump-Metallisierung (5) ein Kanal (8) ausgebildet ist, der den Hohlraum (15) mit einer Umgebung verbindet und somit eine Spannungsentlastungsvorrichtung an der weiteren Hauptfläche (11) bildet, wobei die Spannungsentlastungsvorrichtung eine Verbindung zwischen dem TSV (3) und der Umgebung herstellt, oder
- (j) ein vorbestimmter Bruchpunkt durch einen Bereich gebildet wird, der innerhalb der Schicht der Under-Bump-Metallisierung (5) angeordnet ist, wobei der Bereich mit einem Material gefüllt ist, das eine geringere Bruchfestigkeit als das Material der Under-Bump-Metallisierung aufweist, so dass ein in dem Bereich auftretender Riss oder eine Spalte den Hohlraum (15) mit der Umgebung verbindet, wodurch dieser Bereich eine Spannungsentlastungsvorrichtung bildet.

2. Halbleiterbauelement nach Anspruch 1, wobei der vorbestimmte Bruchpunktbereich als streifenförmiger Bereich innerhalb der Under-Bump-Metallisierung (5) ausgebildet ist.

3. Halbleiterbauelement nach einem der Ansprüche 1 bis 2, wobei der Hohlraum (15) des TSV (3) mit einem Gas oder einer Flüssigkeit gefüllt ist.

4. Verfahren zur Herstellung einer Halbleitervorrichtung, umfassend:
- Bereitstellen eines Halbleitersubstrats (1) mit einem TSV (3), das das Substrat (1) von einer Hauptoberfläche (10) zu einer gegenüberliegenden weiteren Hauptoberfläche (11) durchdringt, wobei das TSV (3) einen Hohlraum (15) umfasst,
- Anordnen einer Deckschicht (2) über dem TSV (3) an der Hauptoberfläche (10) und
- Anordnen einer Under-Bump-Metallisierung (5) und eines Bump-Kontakts (6) auf dem TSV (3) an der weiteren Hauptoberfläche (11), wobei der Bump-Kontakt (6) auf der Under-Bump-Metallisierung (5) angeordnet ist,
**dadurch gekennzeichnet, dass**
- der Hohlraum (15) an der Hauptoberfläche (10) durch die Deckschicht (2) verschlossen ist, und wobei
- (i) in der Under-Bump-Metallisierung (5) ein Kanal (8) ausgebildet ist, wobei der Kanal (8) den Hohlraum (15) mit der Umgebung verbindet und somit eine Spannungsentlastungsvorrichtung bildet, oder
- (j) ein vorbestimmter Bruchpunkt (9) durch einen Bereich gebildet wird, der innerhalb der Schicht der Under-Bump-Metallisierung angeordnet ist, wobei der Bereich mit einem Material gefüllt ist, das eine geringere Bruchfestigkeit als das Material der Under-Bump-Metallisierung aufweist, so dass ein in dem Bereich auftretender Riss oder eine Spalte den Hohlraum (15) mit der Umgebung verbindet, wobei der vorbestimmte Bruchpunkt somit eine Spannungsentlastungsvorrichtung bildet.

## Revendications

1. Dispositif à semi-conducteur, comprenant :
- un substrat semi-conducteur (1) ayant une surface principale (10) et une autre surface principale (11) opposée à la surface principale (10),
- un via traversant (3) traversant le substrat (1) depuis la surface principale (10) jusqu'à l'autre surface principale (11), le via traversant(3) comprenant une cavité (15),
- une couche de recouvrement (2) disposée au-dessus du via traversant(3) au niveau de la surface principale (10),
- un contact à bosse (6) disposé sur le via traversant (3) au niveau de l'autre surface principale (11), et
- une métallisation sous-bossage (5) disposée sur le via traversant(3) au niveau de l'autre surface principale (11), le contact à bossage (6) étant disposé sur la métallisation sous-bossage (5),
**caractérisé en ce que**
- la couche de recouvrement (2) ferme la cavité (15) au niveau de la surface principale (10),
- la métallisation sous-bossage (5) et le contact à bosse (6) recouvrent la cavité (15), et dans lequel
- (i) un canal (8) est formé dans la métallisation sous-bossage (5), le canal (8) reliant la cavité (15) à un environnement, formant ainsi un élément de décompression au niveau de l'autre surface principale (11), l'élément de décompression assurant une communication entre le via traversant (3) et l'environnement, ou
- (j) un point de rupture prédéterminé est formé par une région disposée dans la couche de métallisation sous-bossage (5), ladite région étant remplie d'un matériau qui a une résistance à la rupture inférieure à celle du matériau de la métallisation sous-bossage, de telle sorte qu'une fissure ou une fente se produisant dans ladite région relie la cavité (15) à l'environnement, ladite région formant ainsi un élément de décompression.

2. Dispositif à semi-conducteur selon la revendication 1, dans lequel la région de point de rupture prédéterminé est formée comme une région en forme de bande à l'intérieur de la métallisation sous-bossage (5).

3. Dispositif à semi-conducteur selon l'une des revendications 1 à 2, dans lequel la cavité (15) du via traversant (3) est remplie d'un gaz ou d'un liquide.

4. Procédé de fabrication d'un dispositif à semi-conducteur, comprenant :
- la fourniture d'un substrat semi-conducteur (1) avec un via traversant (3) traversant le substrat (1) depuis une surface principale (10) jusqu'à une autre surface principale opposée (11), le via traversant (3) comprenant une cavité (15),
- disposer une couche de recouvrement (2) au-dessus du via traversant (3) au niveau de la surface principale (10), et
- disposer une métallisation sous-bossage (5) et un contact à bosse (6) sur le via traversant (3) au niveau de l'autre surface principale (11), le contact à bosse (6) étant disposé sur la métallisation sous-bossage (5), **caractérisé en ce que**
- la cavité (15) est fermée au niveau de la surface principale (10) par la couche de recouvrement (2), et dans lequel
- (i) un canal (8) est formé dans la métallisation sous-bossage (5), le canal (8) reliant la cavité (15) à l'environnement, le canal (8) formant ainsi un élément de décompression, ou
- (j) un point de rupture prédéterminé (9) est formé par une région disposée dans la couche de métallisation sous-bossage, ladite région étant remplie d'un matériau qui a une résistance à la rupture inférieure à celle du matériau d' ant la métallisation sous-bossage, de telle sorte qu'une fissure ou une fente se produisant dans ladite région relie la cavité (15) à l'environnement, ledit point de rupture prédéterminé formant ainsi un élément de décompression.
